**Europäisches Patentamt**

**European Patent Office**

**Office européen des brevets**

(11) Numéro de publication : **0 592 324 B1**

(12)

# FASCICULE DE BREVET EUROPEEN

(45) Date de publication du fascicule du brevet :
06.09.95 Bulletin 95/36

(51) Int. Cl.⁶ : **H05K 9/00,** C22C 38/02

(21) Numéro de dépôt : **93402481.1**

(22) Date de dépôt : **08.10.93**

(54) **Dispositif de protection vis-à-vis des champs magnétiques.**

(30) Priorité : **09.10.92 FR 9212028**

(43) Date de publication de la demande :
**13.04.94 Bulletin 94/15**

(45) Mention de la délivrance du brevet :
**06.09.95 Bulletin 95/36**

(84) Etats contractants désignés :
**AT BE CH DE DK ES FR GB GR IE IT LI LU MC NL PT SE**

(56) Documents cités :
**EP-A- 0 503 680**
**DE-C- 832 615**

(73) Titulaire : **ELECTRICITE DE FRANCE Service National**
**2, rue Louis Murat**
**F-75008 Paris (FR)**

(72) Inventeur : **Varese, Christian**
**106 rue des Montforts**
**F-77810 Thomery (FR)**

(74) Mandataire : **Martin, Jean-Jacques**
**Cabinet REGIMBEAU**
**26, Avenue Kléber**
**F-75116 Paris (FR)**

## Description

La présente invention concerne un dispositif de protection vis-à-vis des champs magnétiques pour des systèmes sensibles à ces derniers, tels que des écrans cathodiques.

L'invention trouve notamment une application particulièrement avantageuse dans le domaine de la micro-informatique, où l'on fabrique des consoles "graphiques couleurs" à écrans cathodiques sensibles à la présence de champs magnétiques alternatifs pouvant provoquer des perturbations de l'affichage à l'écran. Ces perturbations sont par exemple des déformations évolutives, des tremblements ou des déchirures des caractères affichés sur l'écran. Ces champs magnétiques perturbateurs peuvent être produits par n'importe quel appareil électrique en fonctionnement situé au voisinage des consoles ou par les lignes du secteur d'alimentation en courant desdites consoles.

Bien entendu, le dispositif de protection permet également de protéger toute sorte d'écrans cathodiques, tels que par exemple des écrans cathodiques de téléviseurs.

Actuellement, pour atténuer les perturbations de l'affichage d'un écran cathodique, par exemple de console d'ordinateur, provoquées par la présence d'un champ magnétique alternatif, on connaît plusieurs techniques dont aucune n'est satisfaisante.

Une première technique consiste à déplacer la console de manière à modifier sa position jusqu'à ce que les perturbations soient atténuées. Cette technique n'est souvent pas efficace. De plus, lorsqu'il y a plusieurs consoles dans un même endroit, suivant la configuration du réseau d'installation des consoles il s'avère difficile de déplacer la ou les consoles perturbées par le champ magnétique.

Une autre solution consiste à équiper la console en question d'un caisson de blindage en alliage du type mumétal (nom déposé) qui permet d'isoler l'écran cathodique d'un champ magnétique alternatif présentant une fréquence de préférence égale à 50 Hz, cette fréquence étant celle du courant du réseau d'alimentation, et donc de supprimer les effets indésirables de ce champ sur l'affichage à l'écran.

Toutefois, ce type de caisson de blindage présente l'inconvénient d'être encombrant, lourd, et inesthétique. De plus, il demande un investissement financier important.

Un assemblage pour le blindage électrique d'un appareil ou de parties d'appareil est connu du DE-C-832615. Cet assemblage comporte trois tubes à section carrée, réalisés au moyen de tôle en ruban. Les tubes sont emboîtés l'un sur l'autre de sorte que l'appareil ou la partie d'appareil soit blindé au moyen de deux parois de tube superposées.

Afin de pallier les inconvénients précités, l'invention propose un dispositif de protection vis-à-vis des champs magnétiques pour des systèmes sensibles à ces derniers, caractérisé en ce qu'il comporte au moins deux feuilles juxtaposées, chacune desdites feuilles ayant des propriétés magnétiques anisotropes et une perméabilité élevée de sorte qu'elle présente une direction de plus faible réluctance, lesdites feuilles étant positionnées dans le champ magnétique au voisinage du système sensible de telle façon que chacune des directions de plus faible réluctance présente une orientation différente afin d'atténuer le champ magnétique traversant lesdites feuilles.

Ainsi selon l'invention, chacune desdites feuilles joue un rôle de polariseur" du champ magnétique la traversant, ce qui permet d'atténuer le rayonnement magnétique perturbateur. En effet, lorsqu'un rayonnement magnétique traverse la première desdites feuilles, le champ magnétique correspondant est à la sortie atténué en module et essentiellement orienté suivant la direction privilégiée de plus faible réluctance de ladite feuille correspondante. De ce fait, lorsque le rayonnement magnétique sortant rencontre une autre feuille juxtaposée à la première et présentant une direction de plus faible réluctance orientée différemment, le champ magnétique étant alors essentiellement orienté suivant la première direction de plus faible réluctance ne peut traverser la deuxième feuille et seule la composante atténuée dudit champ, parallèle à ladite direction de plus faible réluctance de la deuxième feuille, peut la traverser. Après avoir traversé l'ensemble desdites feuilles juxtaposées présentant chacune une direction de plus faible réluctance différente, le rayonnement magnétique est atténué de telle sorte qu'il ne puisse plus perturber le système sensible correspondant. Ce dispositif selon l'invention constitué par lesdites feuilles juxtaposées, est léger et présente un coût de fabrication faible.

En outre, selon l'invention chaque feuille est en matériau métallique.

Avantageusement, pour augmenter l'efficacité des feuilles métalliques du dispositif selon l'invention, placées dans un champ magnétique alternatif chaque feuille présente une épaisseur supérieure à son épaisseur de peau.

En effet, lorsque l'épaisseur de la feuille métallique est supérieure à son épaisseur de peau qui se calcule en fonction de la perméabilité du matériau métallique constituant ladite feuille, de sa conductivité et de la pulsation du champ magnétique alternatif traversant la feuille, les pertes d'énergie par effet Joule dues aux courants de Foucault créés par le champ magnétique alternatif, ne sont pas négligeables, ce qui accentue le phénomène d'atténuation du rayonnement magnétique correspondant.

Selon un mode de réalisation préféré de l'invention, chaque feuille est constituée par un alliage fersilicium à grains orientés, l'orientation des grains définissant la direction de plus faible réluctance.

En outre, selon l'invention, le dispositif comprenant deux feuilles juxtaposées, les deux directions de plus faible réluctance des deux feuilles juxtaposées sont croisées et présentent un décalage angulaire d'environ 90 degrés entre-elles.

D'autre part, selon un mode de réalisation de l'invention, le dispositif comporte trois feuilles juxtaposées de telle sorte que les trois directions de plus faible réluctance soient croisées et présentent deux à deux un décalage angulaire d'environ 120 degrés.

Selon un autre mode de réalisation du dispositif selon l'invention, il comporte quatre feuilles juxtaposées de telle sorte que les quatre directions de plus faible réluctance soient croisées et présentent deux à deux un décalage angulaire d'environ 45 degrés.

La description qui va suivre en regard des dessins annexés, donnés à titre d'exemples non limitatifs, fera bien comprendre en quoi consiste l'invention et comment elle peut être réalisée.

- La figure 1 est un schéma en perspective d'un dispositif selon l'invention à l'intérieur duquel est placée une console à écran cathodique.
- La figure 2a est un schéma en perspective d'une première feuille métallique pliée, constituant le dispositif de la figure 1.
- La figure 2b est un schéma en perspective d'une deuxième feuille métallique pliée, constituant le dispositif de la figure 1.
- La figure 2c est un schéma en perspective d'une troisième feuille métallique pliée, constituant le dispositif de la figure 1.
- La figure 3 est un schéma de l'assemblage des feuilles métalliques des figures 2a, 2b et 2c.
- La figure 4 est un schéma en perspective d'une structure creuse et rigide destinée à être introduite à l'intérieur du dispositif de la figure 1.
- La figure 5 est un tableau comparatif de valeurs expérimentales de composantes de champs magnétiques, mesurées notamment à l'intérieur d'un dispositif selon l'invention.
- La figure 6 est une courbe expérimentale présentant la variation du gain de champ magnétique obtenu à l'intérieur du dispositif de la figure 1, en fonction du champ magnétique inducteur appliqué à l'extérieur dudit dispositif.

En référence aux figues 1, 2a, 2b et 2c, on a représenté un mode de réalisation du dispositif selon l'invention.

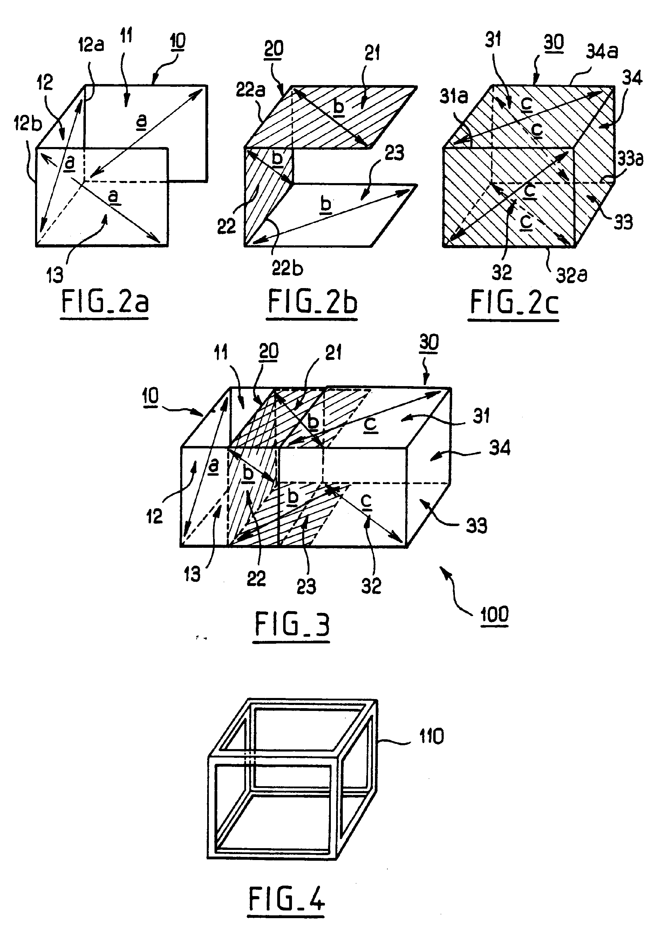

Ce dispositif de protection vis-à-vis des champs magnétiques est ici un caisson 100 de forme parallélépipédique, présentant un fond 101, deux parois latérales 103, 105, une paroi supérieure 102, une paroi inférieure 104 et une ouverture opposée audit fond 101. Dans un exemple typique, ce caisson présente une largeur égale à environ 30 cm, une profondeur d'environ 35 cm et une hauteur d'environ 30 cm. A l'intérieur du caisson 100 est placée par exemple une console d'ordinateur 200 à écran cathodique sensible aux champs magnétiques. La console d'ordinateur 200 est positionnée de sorte que les parois du caisson 100 entourent la console 200. Comme on peut mieux le voir sur les figures 2a, 2b, 2c et 3, le caisson 100 est constitué par un assemblage de trois feuilles métalliques pliées 10, 20, 30.

Chacune des trois feuilles est tout d'abord découpée dans une plaque de forme rectangulaire (non représentée), obtenue par laminage et constituée par exemple par un alliage de fer-silicium à grains orientés, l'orientation des grains dépendant du sens de laminage de la plaque. Cette plaque comporte une perméabilité élevée et des propriétés magnétiques anisotropes qui dépendent de l'orientation des grains et donc de son sens de laminage. Plus particulièrement, la plaque présente une direction de plus faible réluctance définie par l'orientation des grains. Les feuilles en fer-silicium découpées dans ladite plaque, présentant alors les propriétés magnétiques anisotropes et la direction de plus faible réluctance de la plaque, sont pliées en plusieurs plans sensiblement perpendiculaires deux à deux, et sont orientées les unes par rapport aux autres avant d'être assemblées, de telle sorte que chacune des trois feuilles présente dans ses plans orientés une direction de plus faible réluctance, et que cette direction soit différente des directions de plus faible réluctance des plans des autres feuilles.

De manière plus précise, la première feuille 10 est pliée en trois plans 11, 12 et 13, de telle sorte qu'elle comporte un plan central 12 vertical raccordé à deux plans verticaux latéraux 11, 13, par deux lignes de pliage 12a, 12b, les deux plans latéraux 11, 13 s'étendant respectivement à partir des deux lignes de pliage 12a, 12b perpendiculairement au plan 12, en étant placés en regard l'un de l'autre. La première feuille 10 est orientée de telle sorte que chacun des plans 11, 12, 13 présente alors une direction de plus faible réluctance dirigée par exemple suivant la flèche a. La deuxième feuille 20 est pliée également en trois plans 21, 22, 23 et présente un plan central 22 vertical raccordé aux deux autres plans horizontaux supérieur et inférieur 21, 23 par deux lignes de pliage 22a, 22b, les deux plans supérieur et inférieur 21, 23 s'étendant respectivement à partir des deux lignes de pliage 22a, 22b perpendiculairement au plan central 22, en étant placés en regard l'un de l'autre. Dans cette configuration, chaque plan 21, 22, 23 comporte une direction de plus faible réluctance dirigée suivant la flèche b. La troisième feuille métallique est pliée de façon à former un cylindre horizontal de section carrée ouvert à deux extrémités opposées. Elle présente alors quatre plans 31, 32, 33, 34 perpendiculaires deux à deux et quatre lignes de pliage 31a, 32a, 33a, 34a. Les quatre plans 31, 32, 33, 34 comportent une direction de plus faible réluctance dirigée ici suivant la flèche c. Il convient de préciser que selon le mode de réalisation présenté sur la figure 2c, pour des raisons de commodité, le plan horizontal inférieur 33 de la feuille pliée 30 est formé de deux parties égales s'étendant horizontalement respectivement à partir des lignes de pliage 32a, 33a, en direction l'une vers l'autre en étant jointives au milieu dudit plan.

Comme on peut le voir sur la figure 3, le caisson 100 est alors formé par l'assemblage des trois feuilles pliées et orientées 10, 20, 30. Tout d'abord, la feuille métallique 10, et la feuille métallique 20 sont emboîtées l'une dans l'autre de telle sorte que les plans centraux verticaux 12, 22 respectivement des feuilles 10, 20 soient juxtaposés, et plus précisément le plan central 12 est placé du côté extérieur du caisson en parallèle à proximité du plan 22 formant le côté interne adjacent à la console 200, pour former la paroi verticale 101 du fond du caisson 100, les deux directions de plus faible réluctance $\underline{a}$, $\underline{b}$ étant croisées et présentant un décalage angulaire d'environ 90 degrés entre-elles. En outre les deux plans verticaux latéraux 11, 13 de la feuille métallique pliée 10, sont alors positionnés de sorte qu'ils participent à la formation du côté interne respectivement des parois latérales verticales 103, 105 du caisson 100 et les plans horizontaux supérieur et inférieur 21, 23 de ladite feuille 20 sont alors placés perpendiculairement auxdits plans latéraux 11, 13 pour former le côté interne des parois horizontales supérieure et inférieure 102, 104 du caisson 100. La feuille métallique 30 pliée en forme de cylindre est alors glissée sur les deux autres feuilles 10, 20 emboîtées de telle manière que les plans horizontaux supérieur et inférieur 31, 33 de ladite feuille 30 viennent respectivement se juxtaposer du côté extérieur aux plans horizontaux supérieur et inférieur 21, 23 de la feuille 20, pour former les parois horizontales supérieure et inférieure 102, 104 du caisson 100, de telle sorte que les deux directions de plus faible réluctance $\underline{b}$, $\underline{c}$ soient croisées et présentent également un décalage angulaire de 90 degrés entre-elles. De même, les plans verticaux latéraux 32, 34 de ladite feuille 30 viennent se juxtaposer du côté extérieur aux plans latéraux 11, 13 de la feuille 10 pour former les parois latérales 103, 105 du caisson 100, les deux directions de plus faible réluctance $\underline{a}$, $\underline{c}$ étant croisées à 90 degrés l'une de l'autre. Ainsi, chacune des parois du caisson 100 est constituée par deux feuilles métalliques ou plans de feuilles métalliques juxtaposés, un des deux plans formant le côté interne adjacent à la console 200 de la paroi correspondante et l'autre formant le côté externe, et comportant des directions de plus faible réluctance différentes, les deux directions étant croisées à 90 degrés. Chaque paroi du caisson 100 ainsi formée constitue alors un écran vis-à-vis des champs magnétiques perturbateurs.

En théorie, l'atténuation d'un rayonnement magnétique par un écran peut avoir trois origines cumulatives. Une première origine est les pertes d'énergie du rayonnement magnétique par réflexion externe du rayonnement à l'entrée de l'écran en question. Ces pertes dépendent du changement de milieux et non pas de l'épaisseur de l'écran. L'atténuation d'un rayonnement magnétique peut provenir également des pertes d'énergie par absorption du rayonnement pendant la traversée de l'écran. Ces pertes par absorption sont alors proportionnelles à l'épaisseur dudit écran, elles augmentent avec la fréquence du champ magnétique alternatif correspondant et le produit de la conductivité par la perméabilité du matériau constituant l'écran. Il convient de préciser que dans le cas de matériau magnétique la perméabilité diminue lorsque la fréquence augmente. De plus, on peut aussi avoir des pertes d'énergie par "écho" interne du rayonnement à l'intérieur de l'écran. Ces pertes sont souvent négligeables car dans le cas d'un écran épais, l'absorption du rayonnement étant alors importante.

Dans le cas de l'invention, on peut dire que chacune des feuilles métalliques ou plans de feuilles métalliques 11, 12, 13, 21, 22, 23, 31, 32, 33, 34 constituant les parois écrans 101, 102, 103, 104, 105 du caisson 100 joue un rôle de polariseur du champ magnétique perturbateur. Lorsqu'un rayonnement magnétique traverse les feuilles métalliques externes ou plans externes 12, 31, 32, 33, 34 constituant les côtés extérieurs des parois 101, 102, 103, 104, 105, le champ magnétique correspondant est à la sortie atténué et principalement polarisé suivant la direction de plus faible réluctance correspondante. Par exemple, pour la paroi 101, le champ magnétique est à la sortie du premier plan 12 principalement orienté suivant la direction $\underline{a}$ et pour les parois 102, 103, 104, 105, ledit champ magnétique est à la sortie des premiers plans 31, 32, 33, 34 orienté principalement suivant la direction $\underline{c}$. En effet, il convient de préciser que plus la réluctance est faible, plus le flux magnétique traversant la surface correspondante est fort. Ainsi, le champ magnétique passe principalement suivant les directions de plus faible réluctance desdits plans formant les parois. Lorsque le rayonnement magnétique arrive sur les deuxièmes plans internes 22, 21, 13, 23, 11 formant les côtés internes desdites parois 101, 102, 103, 104, 105 du caisson 100, le champ magnétique correspondant étant alors orienté principalement suivant les directions de plus faible réluctance $\underline{a}$ et $\underline{c}$, il ne peut traverser les feuilles métalliques dont les directions de plus faible réluctance sont $\underline{b}$ et $\underline{a}$. En effet, pour la paroi 101, le champ magnétique orienté principalement suivant la direction $\underline{a}$, rencontre le plan 22 dont la direction de plus faible réluctance est la direction $\underline{b}$, et pour les parois 102, 103, 104, 105 le champ orienté suivant la direction $\underline{c}$, rencontre des feuilles dont la direction de plus faible réluctance est la direction $\underline{a}$ ou $\underline{b}$. Ce champ est alors en grande partie absorbé par lesdites feuilles correspondantes et seule une composante très atténuée du champ parallèle auxdites directions $\underline{a}$ et $\underline{b}$ peut passer au travers desdites feuilles. Ainsi, on observe qu'à l'intérieur dudit caisson l'intensité du champ magnétique perturbateur est affaiblie de sorte qu'elle soit ramenée à une valeur ne provoquant pas de gêne pour l'écran cathodique de la console 200.

Par ailleurs, les feuilles métalliques 10, 20, 30 en fer-silicium constituant le caisson 100, présentent ici une épaisseur supérieure ou égale à environ 0,35 millimètres. Si on considère un champ magnétique alternatif provenant du réseau d'alimentation électrique qui présente une fréquence d'environ 50 Hz, cette épaisseur est supérieure à l'épaisseur de peau du matériau desdites feuilles. On rappelle que l'épaisseur de peau δ d'un matériau conducteur se calcule suivant l'expression :

$$\delta = \frac{1}{\sqrt{\pi\,\mu\,\nu\,\gamma}}$$

où μ est la perméabilité magnétique du matériau, ν est la fréquence du champ, et γ la conductivité du matériau.

Dans ce cas, les courants de Foucault créés dans lesdites feuilles par le champ magnétique alternatif jouent un rôle positif pour l'atténuation du rayonnement magnétique par dissipation de l'énergie par effet Joule.

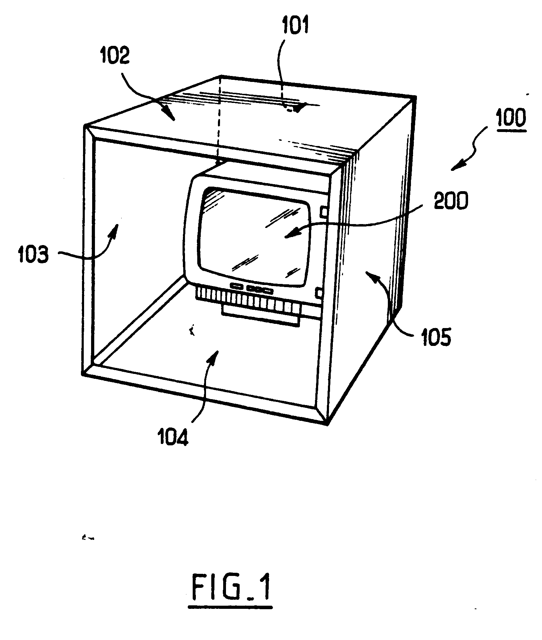

Suivant le mode de réalisation présenté sur la figure 1, les feuilles métalliques pliées 10, 20, 30 et assemblées sont alors recouvertes d'une feuille en matériau de faible résistivité, tels le cuivre ou bien l'aluminium, ce qui permet de réaliser une préatténuation du champs magnétique par réflexion de ce dernier dans ladite feuille afin de faire travailler la partie magnétique du blindage constitué par les feuilles magnétiques 10,20,30 en fer-silicium dans des meilleures conditions à savoir dans des conditions de champs inducteur pour lesquelles la perméabilité magnétique dudit matériau magnétique fer-silicium est proche de son maximum (en s'écartant de la saturation) et donc les pertes de champs par absorption proches du maximum.

En outre, comme le montre mieux la figure 4, le caisson 100 comporte une structure parallélépipédique 110 creuse et rigide, insérée à l'intérieur dudit caisson 100 afin de rigidifier l'ensemble desdites feuilles métalliques 10, 20, 30 assemblées. Cette structure parallélépipédique 110 réalisée en profilés est en fer doux. Elle permet de supprimer les fuites de champs magnétiques aux arêtes 12a, 12b, 22a, 22b, 31a, 32a, 33a, 34a du caisson 100 et réaliser une visière réflectrice d'une partie des lignes de champs pénétrant par l'ouverture et nécessaire à l'obtention de l'efficacité dudit caisson 100 de protection.

Il convient de noter que le dispositif de la figure 1 présente un poids deux fois plus faible qu'un blindage en mumétal présentant la même forme et les mêmes dimensions. De plus, le coût de réalisation du dispositif de la figure 1 est environ quatre fois plus faible que celui d'un blindage équivalent en mumétal.

Par ailleurs, les dimensions du caisson 100 dépendent de celles de l'écran à protéger. Il est à noter que la dalle de l'écran à protéger, positionnée à l'intérieur du caisson, doit avoir un retrait par rapport aux bords de l'ouverture du caisson, ce retrait étant compris entre environ un quart et un tiers de la diagonale de l'ouverture apporte une certaine atténuation du champs pénétrant par l'ouverture.

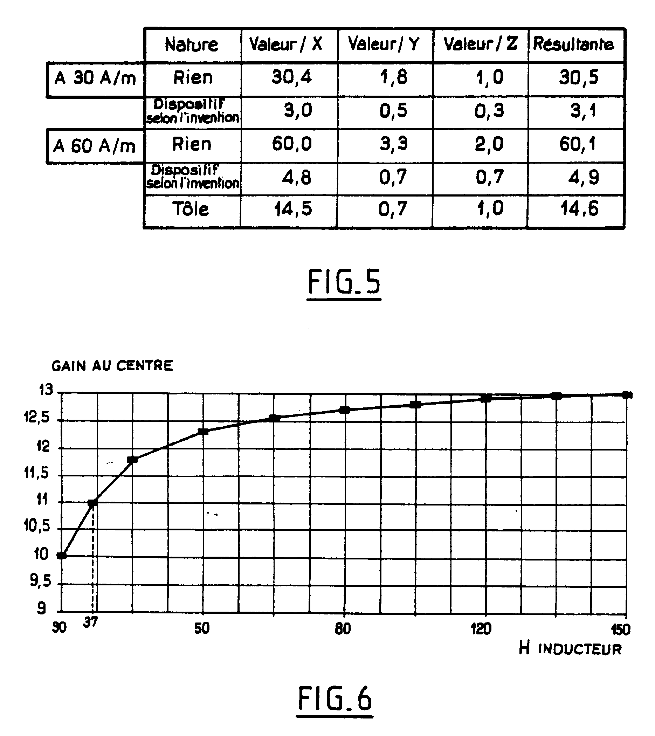

Afin d'illustrer les performances du dispositif de la figure 1, le tableau de la figure 5 montre des résultats de mesures de champs magnétiques, effectuées à l'intérieur dudit dispositif positionné d'une part dans un champ magnétique inducteur de fréquence 50 Hz et de valeur efficace égale à 30 A/m, et d'autre part dans un champ inducteur de fréquence 50 Hz et de valeur efficace égale à 60 A/m. Plus particulièrement, ces mesures sont des valeurs de composantes de champ magnétique suivant trois axes perpendiculaires X, Y, Z, à partir desquelles on calcule au centre du caisson 100 la résultante du champ correspondant. De plus, on peut lire dans ce tableau les mêmes types de mesures effectuées d'une part à l'intérieur d'un blindage tôle et d'autre part dans un milieu sans protection dans les mêmes conditions de champ inducteur à 50 Hz.

L'analyse des résultats montre que le gain obtenu au centre du dispositif de la figure 1, c'est-à-dire le rapport entre le champ inducteur externe et le champ magnétique mesuré, est de l'ordre de 10 pour un champ inducteur externe de 30 A/m et de l'ordre de 12 pour un champ inducteur externe de 60 A/m. On peut dire que le caisson 100 permet alors de diviser par 10 un champ magnétique de fréquence 50 Hz et de valeur efficace 30 A/m et de diviser par 12 un champ magnétique 50 Hz de valeur efficace 60 A/m. Par contre, un simple blindage en tôle permet seulement d'atténuer d'un facteur 4 un champ magnétique externe de fréquence 50 Hz et de valeur efficace 60 A/m.

Le dispositif selon l'invention est donc beaucoup plus performant qu'un simple blindage en tôle.

A titre d'illustration, la figure 6 est une courbe expérimentale d'évolution du gain de champ magnétique obtenu au centre du dispositif de la figure 1, en fonction du champ inducteur extérieur H à 50 Hz. On retrouve sur cette courbe les valeurs du tableau de la figure 4, c'est-à-dire le gain de 10 pour un champ H de 30 A/m et un gain de 12,2 pour un champ H de 60 A/m. On remarquera que la courbe est croissante avec une variation asymptotique pour les grandes valeurs de champ inducteur extérieur. Elle est du type logarithmique, c'est-à-dire que plus le champ inducteur extérieur est fort en valeur efficace, plus le gain obtenu à l'intérieur du caisson est élevé, mais pour les grandes valeurs de champ inducteur la courbe varie peu, le gain obtenu est donc à peu près toujours le même.

Bien entendu, la présente invention n'est nullement limitée à la forme de réalisation décrite et représentée.

Par exemple, suivant une variante de réalisation, chaque paroi du caisson est constituée par trois feuilles métalliques juxtaposées, de telle sorte que leurs directions de plus faible réluctance soient croisées et présentent un décalage de 120 degrés deux à deux.

De même, suivant une autre variante, les parois sont formées de quatre feuilles juxtaposées, les directions de plus faible réluctance étant croisées et présentent un décalage angulaire de 45 degrés deux à deux.

D'autre part, on peut envisager que les feuilles métalliques 10, 20, 30 formant le caisson 100 sont découpées chacune dans une plaque métallique différente, les trois plaques présentant des directions de plus faible réluctance différentes.

## Revendications

1. Dispositif de protection vis-à-vis des champs magnétiques pour des systèmes sensibles à ces derniers, tels que des écrans cathodiques comportant au moins deux feuilles juxtaposées l'une parallèlement à l'autre, chacune desdites feuilles ayant des propriétés magnétiques anisotropes et une perméabilité élevée de sorte qu'elle présente une direction de plus faible réluctance, lesdites feuilles étant positionnées dans le champ magnétique au voisinage du système sensible de telle façon que chacune des directions de plus faible réluctance présente une orientation différente afin d'atténuer le champ magnétique traversant lesdites feuilles.

2. Dispositif selon la revendication 1, caractérisé en ce chaque feuille est en matériau métallique.

3. Dispositif selon l'une des revendications 1 ou 2, caractérisé en ce que chaque feuille présente une épaisseur supérieure à son épaisseur de peau.

4. Dispositif selon l'une des revendications 2 ou 3, caractérisé en ce que chaque feuille est constituée par un alliage fer-silicium à grains orientés, l'orientation des grains définissant la direction de plus faible réluctance.

5. Dispositif selon la revendication 4, caractérisé en ce que chaque feuille métallique présente une épaisseur supérieure ou égale à 0,35 millimètres.

6. Dispositif selon l'une des revendications 1 à 5, caractérisé en ce que les deux directions de plus faible réluctance des deux feuilles juxtaposées sont croisées et présentent un décalage angulaire d'environ 90 degrés entre-elles.

7. Dispositif selon l'une des revendications 1 à 5, caractérisé en ce qu'il comporte trois feuilles juxtaposées de telle sorte que les trois directions de plus faible réluctance soient croisées et présentent deux à deux un décalage angulaire d'environ 120 degrés.

8. Dispositif selon l'une des revendications 1 à 5, caractérisé en ce qu'il comporte quatre feuilles juxtaposées de telle sorte que les quatre directions de plus faible réluctance soient croisées et présentent deux à deux un décalage angulaire d'environ 45 degrés.

9. Dispositif selon l'une quelconque des revendications 1 à 8, caractérisé en ce qu'il comprend un caisson (100) de forme parallélépipédique, entourant le système sensible à protéger, chaque paroi du caisson étant formée d'au moins deux feuilles positionnées en parallèle à proximité l'une de l'autre de telle sorte que chacune des directions de plus faible réluctance desdites feuilles présente une orientation différente afin d'atténuer le champ magnétique traversant lesdites feuilles.

10. Dispositif selon la revendication 9, caractérisé en ce que le caisson (100) est constitué par l'assemblage de trois feuilles métalliques pliées (10,20, 30), chacune desdites feuilles (10,20,30) présentant au moins trois plans, les trois feuilles métalliques (10,20,30) étant positionnées de telle sorte que chacune des parois (101,102,103,104,105) dudit caisson (100) est formée de deux plans en parallèle provenant de deux feuilles métalliques différentes.

11. Dispositif selon l'une des revendications 8 ou 9, caractérisé en ce qu'il comporte une structure parallélépipédique (110), creuse et rigide, réalisée en profilés et destinée à être insérée à l'intérieur dudit caisson (100).

12. Dispositif selon la revendication 11, caractérisé en ce que la structure parallélépipédique (110) est en fer doux.

## Patentansprüche

1. Vorrichtung zum Schutz gegenüber Magnetfeldern für Anordnungen, die dagegen empfindlich sind, wie zum Beispiel Kathodenstrahlbildschirme, mit wenigstens zwei nebeneinander und parallel zueinander angeordneten Folien, von denen jede anisotrope magnetische Eigenschaften und eine hohe Permeabilität hat, derart, daß sie eine Richtung schwächerer Reluktanz zeigt, wobei die Folien im Magnetfeld in der Nähe der empfindlichen Anordnung derart angeordnet sind, daß jede der Richtungen mit schwächerer Reluktanz eine andere Ausrichtung hat, um das durch die Folie hindurchgehende Magnetfeld zu dämpfen.

2. Vorrichtung nach Anspruch 1, dadurch gekennzeichnet, daß jede Folie aus einem Metallmaterial besteht.

3. Vorrichtung nach einem der Ansprüche 1 oder 2, dadurch gekennzeichnet, daß jede Folie eine Dicke hat, die über ihrer Skineffektdicke liegt.

4. Vorrichtung nach einem der Ansprüche 2 oder 3, dadurch gekennzeichnet, daß jede Folie aus einer kornorientierten Eisen-Silicium-Legierung besteht, wobei die Kornorientierung die Richtung der schwächeren Reluktanz bestimmt.

5. Vorrichtung nach Anspruch 4, dadurch gekennzeichnet, daß jede Metallfolie eine Dicke aufweist, die größer als oder gleich 0,35 mm ist.

6. Vorrichtung nach einem der Ansprüche 1 bis 5, dadurch gekennzeichnet, daß die beiden Richtungen schwächerer Reluktanz der nebeneinander angeordneten Folien einander kreuzen und eine Winkelversetzung zueinander von etwa 90° haben.

7. Vorrichtung nach einem der Ansprüche 1 bis 5, dadurch gekennzeichnet, daß sie drei nebeneinander angeordnete Folien umfaßt, derart, daß die drei Richtungen schwächerer Reluktanz einander kreuzen und paarweise eine Winkelversetzung von etwa 120° zeigen.

8. Vorrichtung nach einem der Ansprüche 1 bis 5, dadurch gekennzeichnet, daß sie vier nebeneinander angeordnete Folien umfaßt, derart, daß die vier Richtungen schwächerer Reluktanz einander kreuzen und paarweise eine Winkelversetzung von etwa 45° zeigen.

9. Vorrichtung nach einem der Ansprüche 1 bis 8, dadurch gekennzeichnet, daß sie einen parallelepipedförmigen Kasten (100) umfaßt, der die zu schützende empfindliche Anordnung umschließt, wobei jede Wand des Kastens aus wenigstens zwei Folien gebildet ist, die parallel nahe aneinander angeordnet sind, derart, daß jede Richtung schwächerer Reluktanz der Folien eine andere Ausrichtung hat, um das durch die Folien hindurchgehende Magnetfeld zu dämpfen.

10. Vorrichtung nach Anspruch 9, dadurch gekennzeichnet, daß der Kasten (100) dadurch gebildet ist, daß drei umgebogene Metallfolien (10, 20, 30) zusammengesetzt sind, wobei jede Folie (10, 20, 30) wenigstens drei Ebenen aufweist, die drei Metallfolien (10, 20, 30) so angeordnet sind, daß jede Wand (101, 102, 103, 104 105) des Kastens (100) von zwei parallelen Ebenen gebildet wird, die von zwei verschiedenen Metallfolien stammen.

11. Vorrichtung nach einem der Ansprüche 8 oder 9, dadurch gekennzeichnet, daß sie eine hohle und starre Parallelepipedkonstruktion (110) umfaßt, die aus Profilen gebildet und dazu bestimmt ist, in das Innere des Kastens (100) eingesetzt zu werden.

12. Vorrichtung nach Anspruch 11, dadurch gekennzeichnet, daß die Parallelepipedkonstruktion (110) aus Weicheisen besteht.

## Claims

1. A magnetic field protection device for systems that are sensitive to magnetic fields, such as cathode ray tubes, comprising at least two mutually parallel juxtaposed sheets, each of said sheets having anisotropic magnetic properties and high permeability such as to present a direction of least reluctance, said sheets being positioned in the magnetic field in the vicinity of the sensitive system in such a manner that each of the directions of least reluctance is oriented in a different direction so as to attenuate the magnetic field passing through said sheets.

2. A device according to claim 1, characterized in that each sheet is made of a magnetic material.

3. A device according to claim 1 or 2, characterized in that each sheet is thicker than its skin thickness.

4. A device according to claim 2 or 3, characterized in that each sheet is constituted by a silicon-iron alloy having oriented grains, the orientation of the grains defining the direction of least reluctance.

5. A device according to claim 4, characterized in that each metal sheet has a thickness that is greater than or equal to 0.35 millimeters.

6. A device according to any one of claims 1 to 5, characterized in that the two directions of least reluctance of two juxtaposed sheets are crossed and present an angular offset of about 90° between each other.

7. A device according to any one of claims 1 to 5, characterized in that it includes three juxtaposed sheets such that the three directions of least reluctance are crossed and present an angular offset in pairs of about 120°.

8. A device according to any one of claims 1 to 5, characterized in that it includes four juxtaposed sheets such that the four directions of least reluctance are crossed and present an angular offset in pairs of about 45°.

9. A device according to any one of claims 1 to 8, characterized in that it comprises a rectangular box (100) surrounding the sensitive system to be protected, each wall of the box being made up of at least two sheets disposed in parallel in mutual proximity in such a manner that each of the directions of least reluctance of said sheets is oriented in a different direction so as to attenuate the magnetic field passing through said sheets.

10. A device according to claim 9, characterized in that the box (100) is made up of an assembly of three folded metal sheets (10. 20, 30), each of said sheets (10, 20, 30) presenting at least three planes, the three metal sheets (10, 20, 30) being positioned in such a manner that each of the walls (101, 102, 103, 104, 105) of said box (100) is made up of two parallel planes coming from two different metal sheets.

11. A device according to claim 8 or 9, characterized in that it includes a hollow and rigid rectangular framework (110) made of bars and designed to be inserted inside said box (100).

12. A device according to claim 11, characterized in that the rectangular framework (110) is made of soft iron.

FIG.1

FIG.2a

FIG.2b

FIG.2c

FIG.3

FIG.4

| | Nature | Valeur / X | Valeur/ Y | Valeur / Z | Résultante |
|---|---|---|---|---|---|
| A 30 A/m | Rien | 30,4 | 1,8 | 1,0 | 30,5 |
| | Dispositif selon l'invention | 3,0 | 0,5 | 0,3 | 3,1 |
| A 60 A/m | Rien | 60,0 | 3,3 | 2,0 | 60,1 |
| | Dispositif selon l'invention | 4,8 | 0,7 | 0,7 | 4,9 |
| | Tôle | 14,5 | 0,7 | 1,0 | 14,6 |

## FIG.5

GAIN AU CENTRE

## FIG.6